# EUROPEAN PATENT SPECIFICATION

(11) **EP 0 412 119 B1**
(45) Date of publication and mention of the grant of the patent: **19.07.1995**
(21) Application number: 89905956.2
(22) Date of filing: 26.04.1989
(51) Int. Cl.: H01R 13/24, G01R 1/073

(54) **STATIC-FREE INTERROGATING CONNECTOR FOR ELECTRIC COMPONENTS**
ANTISTATISCHER ABFRAGEVERBINDER FÜR ELEKTRISCHE KOMPONENTEN
CONNECTEUR D'INTERROGATION NON STATIQUE POUR COMPOSANTS ELECTRIQUES

(30) Priority: 27.04.1988 US 187665
(43) Date of publication of application: 13.02.1991
(73) Proprietor: I-STAT CORPORATION, Princeton, NJ 08540 (US)
(72) Inventor: LAUKS, Imants, R., Morrisville, PA 19106 (US); ZELIN, Michael, P., Plainsboro, NJ 08536 (US)
(74) Representative: Martin, Jean-Jacques
(86) International application number: US8901796
(87) International publication number: WO8910639

(56) References cited:
- US-A- 3 903 385
- US-A- 4 070 557
- US-A- 4 358 173
- US-A- 4 359 252
- US-A- 4 708 659

## Description

### Field of the Invention

This invention relates to an improved connector for electric components. In addition, this invention relates to a connector which is also useful for automatically identifying a particular component such as a passive circuit or an integrated circuit as being a member of one of several classes of components. The connector avoids certain common connection problems, such as damage caused by static electricity or the like.

### Background of the Invention

Normally, electric components are identified by visual inspection of identification data printed on labels, directly on the component, or similarly. However, it is desirable to provide automatic identification of a particular circuit as belonging to a class of circuits. For example, it is desirable to automatically identify a particular circuit as being one of a particular class upon placing the circuit into a test apparatus, such that the test apparatus is able to select appropriate test signals or other test conditions to apply to the circuit for test, evaluation, or calibration purposes. This would eliminate the requirement that the operator independently identify the type of circuit being tested, which in turn would reduce the chance of error in such procedures.

As is well known, integrated circuits employing complementary metal-oxide semiconductor (CMOS) elements must be shielded from any static electricity on any circuit to which they are connected because CMOS elements are easily destroyed by electric charge. Accordingly, in the design of a connector device for use with CMOS circuits, it is desirable that means be provided to ground any static electricity appearing either on the connector itself or on the circuits to be connected to avoid catastrophic damage to the CMOS elements. As is known in the art, CMOS elements are advantageously used in test circuits because of their favorable operating characteristics in the amplification of low-level signals.

US-A-3903385 discloses a connector for contacting an electric component comprising : a housing including means for locating said component in a specified physical relationship to said housing ; a plurality of contact members carried by and biased with respect to said housing so as to be urged into physical contact with a predetermined electric component in said specified physical relationship to said housing ; conductor means located such that at least some of said biased contact members are urged into electrically conductive relation with said conductor means when no electric component is in said specified physical relationship to said housing, and such that selected contact members are displaced out of their electrically conductive relation to said conductor means when an electric component is in said specified physical relationship to said housing, different combinations of said contact members being displaced by different electric components.

### Summary of the Invention

The present invention provides a connector device as defined in claim 1 for making connections to an electric circuit. It can be used for connections to all manner of electric circuits but is especially useful in making connection to integrated circuits as will be detailed below. The present invention provides also a system comprising in combination a connector and an electric component as defined in claim 10. The connector comprises a housing which carries a number of contact members which each comprise preferably stationary and movable portions. In a preferred embodiment of the invention, the movable portions are normally disposed in rest positions in which they are in electrically conductive relation with a grounded shorting bar. When a circuit is connected to the connector device, some of the movable portions of the contact members are displaced, such that their disconnection from the shorting bar can be detected.

The inventive connector device can be employed to detect which of its contact members have been displaced by connection to circuit elements on the circuit connected to the device, which have been displaced by nonactive elements on the circuit, and which have not been displaced. A sequence of signals derived from this information can be compared to stored predetermined sequences of signals to identify or classify the circuit that has been connected.

The fact that the contact members are all connected to the grounded shorting bar prior to their displacement therefrom advantageously provides a convenient means of absorbing any static electricity on the contact members or on the circuit that has been connected to the connector device.

### Brief Description of the Drawing

These and other objects, features and advantages of the invention will be better understood from the accompanying drawing, in which:
Fig. 1 shows a cross-sectional view of a connector according to the invention;
Fig. 2 shows a cross-sectional view comparable to that of Fig. 1, the connector having had an electric component connected thereto;
Fig. 3 shows a schematic circuit diagram of a device employing the connector according to the invention for use in identifying an electric component; and
Fig. 4 shows schematically how the connector device derives sequences of identification signals from electric components to be tested according to the invention.

### Description of the Preferred Embodiments

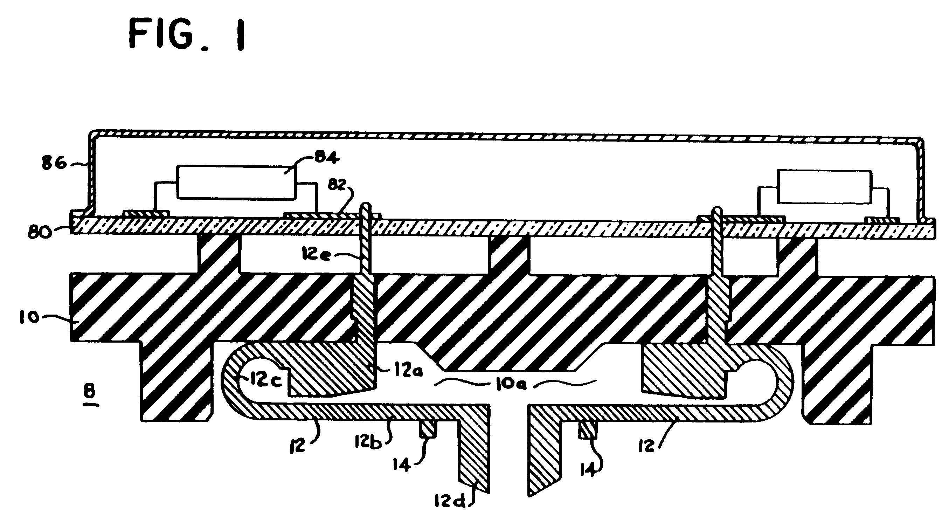

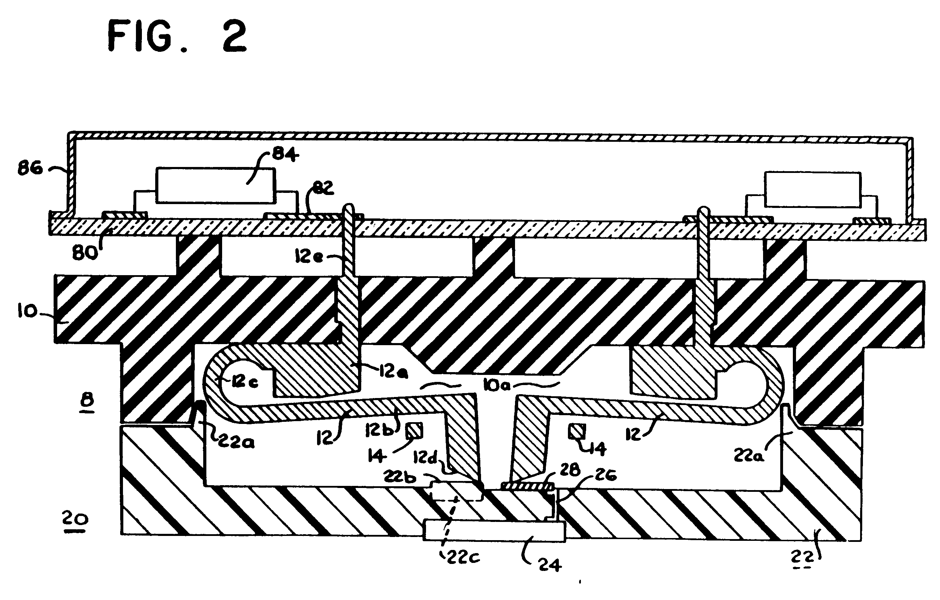

As mentioned, Fig. 1 shows a cross-sectional view of a connector 8 according to the invention, while Fig. 2 shows a corresponding view thereof after an electric component 20 has been inserted therein. In the following, identical reference numerals are used with respect to each view.

Connector 8 according to the invention comprises a housing 10 which carries a plurality of contact members 12. The housing 10 is shaped to comprise a recess 10a in which the contact members 12 are disposed, and which is shaped to receive electric components to be connected in a predetermined physical relation, such that the contact members 12 are directly juxtaposed to electrical contact elements on the component in a predetermined manner. As can be seen, each contact member 12 comprises a stationary portion 12a which is fixed with respect to the housing 10, and a movable portion 12b which is joined to the fixed portion by a U-shaped portion 12c, such that the contact member is biased outwardly. This allows a probe portion 12d of the contact member 12 to be displaced somewhat when brought into direct contact with an electric component to be tested. If the electric component comprises a contact element which is contacted by the contact member 12, very reliable electrical contact is made therebetween.

On the opposite side of housing 10 is mounted a printed circuit board 80 on which are disposed printed wiring 82 and electronic packages 84 such as integrated circuits. Illustratively, the signals from the components that are connected to contacts 12 are low-level, high impedance signals and the circuitry on board 80 is used to amplify such signals and convert them to low impedance signals for transmission to test circuitry. In such circumstances the integrated circuits are likely to be very sensitive to noise and vulnerable to damage by static. Noise protection is provided by encasing the circuit board in a conductive metal cover 86.

To protect against static, the housing 10 also has mounted thereto two or more grounded shorting bars 14. As shown in Fig. 1, the contact members 12 are shaped to be biased into electrically conductive relation with the shorting bars, which thus define the rest positions of the contact members. Thus, if a voltage is applied to any one of the contact members 12, one of shorting bars 14 will ground that voltage as long as the contact member 12 is in the rest position.

Fig. 2 depicts a view comparable to Fig. 1, wherein an electric component 20 has been connected to the connector 8 of the invention by moving at least one of connector 8 and component 20 toward the other in the direction indicated by the double-headed arrow of Fig. 2. Suitable means for effecting such motion will be apparent to those skilled in the art. The electric component 20 includes a body portion 22 which is shaped to comprise key means 22a interfitting with the housing 10 of the connector in a predetermined manner, such that a predetermined physical relationship is established therebetween. Alternatively, other locating means such as alignment pins may be used. Mounted in the body 22 of component 20 is, illustratively, an integrated circuit chip 24 comprising active circuit components. Integrated circuit chip 24 is connected by conductors 26 extending through the body portion 22 or otherwise to one or more contact elements 28. Contact element 28 as shown is in electrical contact with the probe portion 12d of one of the contact members 12 of the connector 8 of the invention. Thus, when the electric component 20 is placed into the predetermined physical relationship with the connector 8, one or more contact members 12 are displaced from their rest position against the shorting bar 14, creating an open circuit therebetween.

The body 22 of the electric component 20 to be tested may also be formed to comprise one or more raised members 22b, which similarly displace other contact members 12 from the shorting bar 14. An open circuit is again created. According to the invention, the connector 8 may be employed in connection with a device for distinguishing between contact members 12 which are connected to the integrated circuit chip (as on the right of Fig. 2) upon displacement from their rest position against the shorting bar 14, and those which are simply open-circuited by raised members 22b formed on the body 22.

A third possibility is that a portion of the body 22 is shaped to comprise a recess 22C. This recess is aligned with a contact member so that when the electric component 20 to be tested is connected to the connector 8, the contact member 12 is not displaced from its electrically conductive relation with the shorting bar 14. As a result, the ground potential present on the shorting bar 14 will therefore continue to be detectable at the terminal portion 12e of that contact member 12.

There are thus three or more possible signal characteristics detectable at the terminal portions 12e of the contact members 12. More specifically, when an electric component 20 is connected to connector 8, a ground potential connected to the shorting bar 14 can be detected at the terminal portion 12e of a contact member 12 at locations where the body 22 of component 20 has a corresponding recess 22C formed therein. An open circuit is detectable when a raised portion 22b of the body of the electric component is juxtaposed to the contact member 14 (left side of Fig. 2); and varying circuit characteristics may be detected, depending on the precise electrical characteristics of the integrated circuit chip 24, when the contact member contacts a contact element 28 connected to the chip (right side of Fig. 2). The combination of these three or more distinguishable signals provided at the various terminal portions 12e of the contact members 12 with respect to a particular electric component can conveniently be used to characterize the component, that is, to identify it as being a member of a particular class of components.

More particularly, it is readily possible to connect a microprocessor and an associated read-only memory (ROM) or the equivalent to the terminal portions 12e of the equivalent to the terminal portions 12e of the contact members 12, to compare the set of signals detected with respect to a particular electric component to a number of stored sets of signals, and to identify the particular electric component as belonging to a class of such components when a correspondence therebetween is detected.

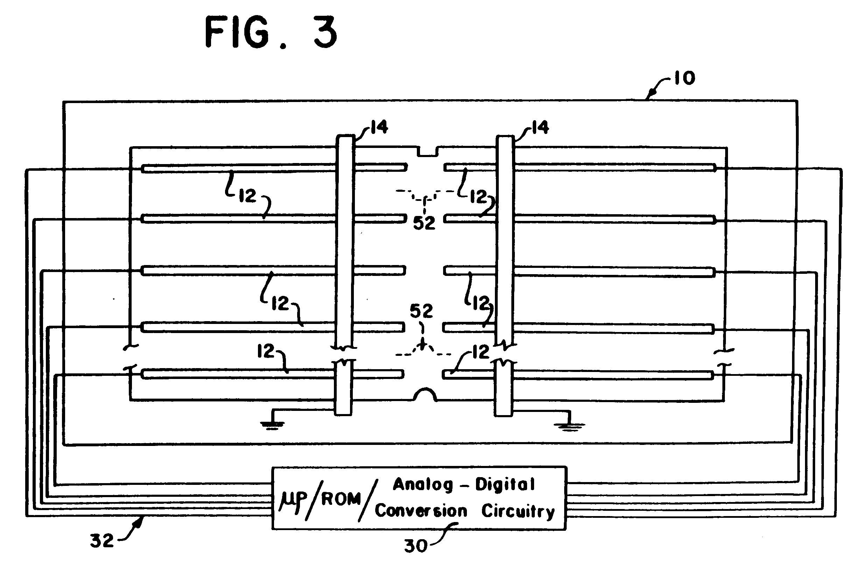

Fig. 3 shows a plan view of the connector 8 of the invention together with a schematic diagram of its connections to a device 30 for identifying a particular electric component juxtaposed thereto.

Shorting bars 14 are shown in Fig. 3 as connected to ground potential. A plurality of contact members 12 are also shown. Clearly, these can be multiplied to any degree desired. Contact members 12 are connected by conductors 32 to a microprocessor/ROM/analog to digital conversion circuitry combination 30, by which a set of signals detected by way of the contact members 12 with respect to a particular electric component are compared to stored sets of comparable signals in order to determine the identity of the component.

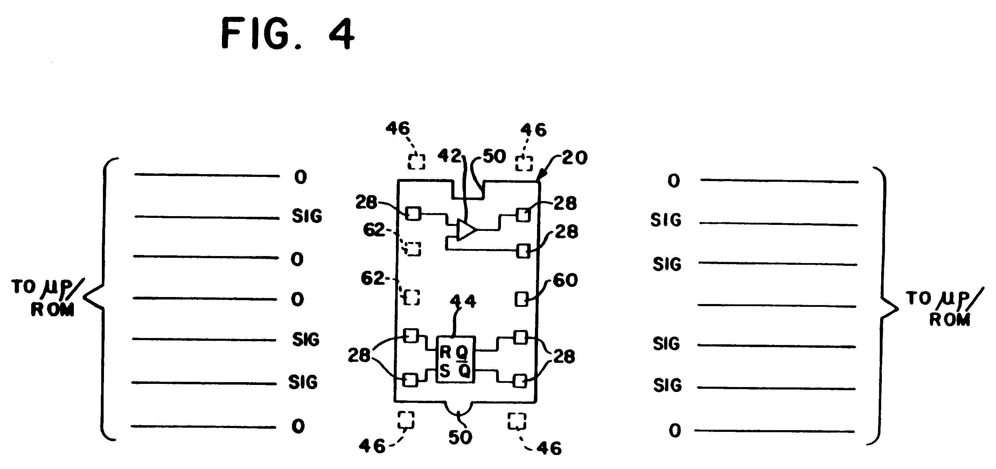

Fig. 4 shows an example of the signals which may be detected with respect to a particular electric component 20. The electric component 20 comprises two active electronic elements, depicted schematically as an amplifier 42 and a flip-flop 44, which are connected to seven contact elements 28 at ten possible locations on the body 22 of the component 20. In the example given, which is by no means limiting of the invention, the connector 8 includes two additional contact members 12 disposed at locations 46 at each end. That is, the connector 8 in the example can make connection with up to fourteen contact elements 28.

The electric component 20 has key means 50 for interacting with corresponding key means 52 (Fig. 3) formed on the connector 8 according to the invention, such that when the component 20 is placed in the predetermined physical relation to the connector 8, the contact elements 28 on the component 20 are precisely juxtaposed with respect to the contact members 12 on the connector 8. The connection of the contact elements 28 of the electric component 20 to the amplifier 42 and the flip-flop 44 can be detected by the microprocessor/ROM unit 30 when interrogated by appropriate signals.

Typical connections which may be detected are shown on the left and right sides of the diagram of Fig. 4. As indicated, a signal ("Sig") is present on the connecting pins 28 to which the amplifier 42 and flip-flop 44 are connected. That is, the fact that an active circuit element is connected to the contact member can be detected by supply of appropriate interrogation signals thereto. No signal is shown with respect to one location 60, where a raised member 22b displaces the corresponding contact member 12 from the shorting bar 14, and to which no circuit elements are connected, as shown on the right side of Fig. 2. A ground potential is shown at two positions 62 on the left side of Fig. 2 where a recess is formed in the component 20 such that the corresponding contact element is not displaced from the shorting bar 14. Finally, at the end positions 46 which are not affected by the presence of the component 20, the contact numbers 12 are not displaced from the shorting bars, and ground potential is also detected.

The fact that the contact members 12 are in contact with the shorting bars 14 prior to connection with component 20 prevents any buildup of static electricity prior to their contacting the component 20. Thus, even if the circuitry 84 comprises a very delicate CMOS circuit, it will not be damaged by static electricity. Moreover, when component 20 is first brought into contact with contact members 12, the contact members will still be in contact with shorting bars 14. As a result, any static electricity on component 20 will be discharged through contact members 12 and shorting bars 14 before the contact members are lifted off the shorting bars by component 20.

It will also be appreciated that after a particular component has been categorized by comparison of the signals detected via the contact members 12 to stored sets of signals, the component can be tested and characterized and/or calibrated by supplying particular signals thereto. This might conveniently be accomplished under the control of microprocessor/ROM/analog to digital conversion circuitry unit 30. Advantageously, the particular signals applied to the component after identification can be varied depending on the identity of the component.

It will be recognized that a number of different interrogation signal sequences may be usefully employed in connection with the connector of the invention. For example, in a two-stage identification process, the component might first be characterized by identification of the contact elements thereof to which active circuit elements are connected. Thereafter, specified interrogation signals useful in differentiating one type of component having active elements connected to those contact elements from another may be applied, e.g., to some of the contact elements, and the results monitored. Similarly wide variation in the possible test and calibration signal sequences will also be apparent to those of skill in the art.

Therefore, while a preferred embodiment of the invention has been described, the above disclosure thereof should be considered as exemplary only and not as a limitation thereon. The invention is limited only by the following claims.

## Claims

1. A connector (8) for contacting an electric component (20) comprising:
a housing (10) including means (10a,52) for locating said component (20) in a specified physical relationship to said housing (10);
conductor means (14) and a plurality of contact members (12) carried by and biased with respect to said housing (10) between a first and a second positions, such that at least some of said biased contact members (12) in said first position, are urged into electrically conductive relation with said conductor means (14) when no electric component (20) is in said specified physical relationship to said housing (10), and such that selected contact members (12) are urged into physical contact with a predetermined electric component (20) in said specified physical relationship to said housing and displaced in said second position out of their electrically conductive relation to said conductor means (14) when said electric component (20) is in said specified physical relationship to said housing (10), characterized in that it further comprises means (80,82,84,30) connected to said contact members (12) for determining the combination of displacements of said contact members (12) when an electric component (20) is in said specified physical relationship to said housing (10), and for identifying the component (20) responsive thereto.

2. The connector of claim 1, wherein said means (80,82,84,30) for identifying comprises means (30) for comparing a combination of signals detected with respect to said contact members (12) to stored data representing a plurality of stored combinations of signals, and for identifying the component (20) responsive to correspondence between the detected combination of signals and one of the stored combinations of signals.

3. The connector of one of claims 1 or 2, further comprising means (84,30) for application of predetermined signals to said component (20) while in said specified physical relationship to said housing (10), and means (84,30) for monitoring the response of the component (20) thereto.

4. The connector of one of claims 1 or 3 wherein said contact members (12) of said connector (8) each comprises a fixed portion (12a) mounted in said housing (10), a terminal portion (12e) for electrical connection to a conductor (82), and a movable portion (12b) at least partially exposed with respect to said housing (10) and adapted to engage a contact element (28) on said electric component (20), at least said movable portion (12b) being biased into a rest position from which it is displaced when it engages a contact element (28) on said component (20).

5. The connector of claim 4 wherein said conductor means comprises shorting means (14) adapted to physically contact can be in electrically conductive relation with the movable portions (12b) of at least some of said contact members (12) when in said rest position.

6. The connector of claim 5 wherein said plurality of said contact members (12) are arranged in at least one row and said shorting means (14) comprising a conductive bar extending transversely to said row.

7. The connector of one of claims 4 to 6, wherein said contact members (12) are each formed to define a bent portion (12c) between said fixed portion (12a) and said movable portion (12b), such that said bent portion (12c) flexes in order to provide said bias to said movable portion (12b).

8. The connector of claim 6, wherein said shorting bar (14) extends transversely to the movable portions (12b) of said row of contact members (12).

9. The connector of one of claims 5, 6 or 8 wherein the shorting means (14) is grounded.

10. A system comprising in combination a connector (8) according to one of claims 1 to 9 and an electric component (20), said component (20) comprising a body (22) comprising locating means (50) and a number of exposed contact elements (28), said locating means (50) of the component (20) being adapted for mating with said locating means (52) on the connector (8), such that the physical position of the contact elements (28) on the component (20) is defined with respect to the contact members (12) of the connector (8).

11. The system of claim 10, wherein when an electric component (20) is in said specified physical relationship to said housing (10) at least some of the contact members (12) are in electrically conductive relation to contact elements (28) on said component (20), and wherein said at least some of the contact members (12) are identified by said means for determining (80,82,84,30).

12. The system of one of claims 10 or 11, wherein the components (20) of each of a plurality of classes of electrical components provide unique combinations of signals to said contact members (12) when in said specified physical relationship to said housing (10).

13. The system of claim 12, wherein the components (20) of each of the classes have physical configurations such that when the components (20) are placed in said specified physical relationship to said housing (10) different combinations of said contact members (12) unique to each of said classes are displaced from their electrically conductive relation to said conductor means (14).

14. The system of claim 13, wherein some of said combinations of said contact members (12) are displaced by electrically insulative members (22b) on said component (20).

15. The system of one of claims 10 to 14 wherein different electric components (20) displace different contact members (12).

## Patentansprüche

1. Ein Steckverbinder (8) zur Kontaktierung eines elektrischen Bauteils (20) bestehend aus:
einem Gehäuse (10) einschließlich Einrichtung (10a, 52) zur Positionierung von besagtem Bauteil in eine spezifizierte physikalische Beziehung zu besagtem Gehäuse (10);
Leitungseinrichtung (14) und einer Vielzahl von Kontaktgliedern (12), die von besagtem Gehäuse (10) getragen werden und in bezug auf dieses zwischen einer ersten Stellung und einer zweiten Stellung so vorgespannt sind, daß zumindest einige der vorgespannten Kontaktglieder (12) in besagter ersten Stellung in elektrisch leitende Beziehung zu besagter Leitungseinrichtung (14) gezwungen werden, wenn sich kein elektrisches Bauteil (20) in besagter spezifizierten physikalischen Beziehung zu besagtem Gehäuse (10) befindet, dergestalt daß ausgewählte Kontaktglieder (12) gezwungen werden, in physikalischen Kontakt mit einem vorbestimmten elektrischen Bauteil (20) in besagter spezifizierten physikalischen Beziehung mit besagtem Gehäuse zu treten, und in besagter zweiten Stellung aus ihrer elektrisch leitenden Beziehung zu besagter Leitungseinrichtung (14) ausgelenkt werden, wenn besagtes elektrisches Bauteil (20) sich in besagter spezifizierten physikalischen Beziehung zu besagtem Gehäuse (10) befindet,
dadurch gekennzeichnet, daß er desweiteren die mit besagten Kontaktgliedern (12) verbundene Einrichtung (80, 82, 84, 30) umfaßt zur Bestimmung der Kombination von Auslenkungen von besagten Kontaktgliedern (12), wenn ein elektrisches Bauteil (20) sich in besagter spezifizierten physikalischen Beziehung zu besagtem Gehäuse (10) befindet, und zur Identifizierung des hierauf ansprechenden Bauteils (20).

2. Der Steckverbinder gemäß Anspruch 1, dadurch gekennzeichnet, daß besagte Identifizierungseinrichtung (80, 82, 84, 30) die Einrichtung (30) umfaßt zur vergleichenden Gegenüberstellung von einer Kombination von in bezug auf besagte Kontaktglieder (12) erfaßten Signalen einerseits und gespeicherten, eine Vielzahl von gespeicherten Signalkombinationen repräsentierenden Daten andererseits und zur Identifizierung des Bauteils (20), das bei Übereinstimmung zwischen der erfaßten Signalkombination und einer der gespeicherten Signalkombinationen anspricht.

3. Der Steckverbinder gemäß Anspruch 1 oder 2, desweiteren umfassend Einrichtung (84, 30) zur Einspeisung von vorbestimmten Signalen in besagtes Bauteil (20), während sich dieses in besagter spezifizierten physikalischen Beziehung mit besagtem Gehäuse (10) befindet, und Einrichtung (84, 30) zur Überwachung des Antwortsignals des Bauteils (20) darauf.

4. Der Steckverbinder gemäß Anspruch 1 oder 3, dadurch gekennzeichnet, daß besagte Kontaktglieder (12) von besagtem Steckverbinder (8) jeweils einen in besagtem Gehäuse (10) gelagerten feststehenden Abschnitt (12a), einen Endabschnitt (12e) zur Herstellung einer elektrischen Verbindung mit einem Leiter (82) und einen beweglichen
Abschnitt (12b) aufweisen, der zumindest teilweise in bezug auf besagtes Gehäuse (10) freigelegt ist und so angepaßt ist, daß er in ein Kontaktelement (28) an besagtem elektrischen Bauteil (20) eingreift, wobei zumindest besagter beweglicher Abschnitt (12b) in einer Ruhestellung vorgespannt ist, aus der er verschoben wird, wenn er in ein Kontaktglied (28) an besagtem Bauteil (20) eingreift.

5. Der Steckverbinder gemäß Anspruch 4, dadurch gekennzeichnet, daß besagte Leitungseinrichtung die Kurzschlußeinrichtung (14) umfaßt, die so ausgelegt ist, daß sie sich in besagter Ruhestellung mit dem beweglichen Abschnitt (12b) von zumindest einigen der besagten Kontaktgliedern (12) körperlich in Berührung und in elektrisch leitender Beziehung befindet.

6. Der Steckverbinder gemäß Anspruch 5, dadurch gekennzeichnet, daß besagte Vielzahl von besagten Kontaktgliedern (12) zumindest in einer Reihe angeordnet sind und daß besagte eine Zuführungsschiene umfassende Kurzschlußeinrichtung (14) sich quer zu besagter Reihe erstreckt.

7. Der Steckverbinder gemäß den Ansprüchen 4 bis 6, dadurch gekennzeichnet, daß besagte Kontaktglieder (12) jeweils so geformt sind, daß sie einen Bogen (12c) zwischen besagtem feststehenden Abschnitt (12a) und besagtem beweglichen Abschnitt (12b) definieren, wobei besagter Bogen (12c) federt, um besagten beweglichen Abschnitt mit besagter Vorspannung (12b) zu versehen.

8. Der Steckverbinder gemäß Anspruch 6, dadurch gekennzeichnet, daß sich besagte Kurzschlußschiene (14) quer zu den beweglichen Abschnitten (12b) von besagter Reihe von Kontaktgliedern (12) erstreckt.

9. Der Steckverbinder gemäß den Ansprüchen 5, 6 oder 8, dadurch gekennzeichnet, daß die Kurzschlußeinrichtung (14) geerdet ist.

10. Ein System umfassend eine Kombination aus einem Steckverbinder (8) entsprechend einem der Ansprüche 1 bis 9 und einem elektrischen Bauteil (20), dadurch gekennzeichnet, daß besagtes Bauteil (20) einen Körper (22) aufweist, der eine Positionierungseinrichtung (50) und eine Anzahl von freigelegten Kontaktelementen (28) umfaßt, wobei besagte Positionierungseinrichtung (50) des Bauteils (20) so ausgelegt ist, daß sie sich mit besagter Positionierungseinrichtung (50) an dem Steckverbinder (8) so paart, daß die physikalische Stellung der Kontaktelemente (28) an dem Bauteil (20) im Verhältnis zu den Kontaktgliedern (12) an dem Steckverbinder (8) definiert ist.

11. Das System gemäß Anspruch 10, dadurch gekennzeichnet, daß in dem Falle, in dem sich ein elektrisches Bauteil (20) in besagter spezifizierten physikalischen Beziehung mit besagtem Gehäuse (10) befindet, sich zumindest einige der Kontaktglieder (12) in elektrisch leitender Beziehung zu Kontaktelementen (28) an besagtem Bauteil (20) befinden und daß besagte zumindest einige Kontaktglieder (12) von besagter Bestimmungseinrichtung (80, 82, 84, 30) identifiziert werden.

12. Das System gemäß Anspruch 10 oder 11, dadurch gekennzeichnet, daß die Bauteile (20) einer jeden Klasse von einer Vielzahl von Klassen von elektrischen Bauteilen einzigartige Kombinationen von Signalen an besagte Kontaktglieder (12) liefern, wenn sie sich in besagter spezifizierten physikalischen Beziehung mit besagtem Gehäuse (10) befinden.

13. Das System gemäß Anspruch 12, dadurch gekennzeichnet, daß die Bauteile (20) einer jeden Klasse solche physikalischen Konfigurationen aufweisen, daß bei einer Plazierung von besagten Bauteilen (20) in besagte spezifizierte physikalische Beziehung zu besagtem Gehäuse (10) verschiedene und für jede der besagten Klassen einzigartige Kombinationen von besagten Kontaktgliedern (12) aus ihrer elektrisch leitenden Beziehung mit besagter Leitungseinrichtung (14) ausgelenkt werden.

14. Das System gemäß Anspruch 13, dadurch gekennzeichnet, daß einige der besagten Kombinationen von besagten Kontaktgliedern (12) von elektrisch isolierenden Gliedern (22b) an besagtem Bauteil (20) ausgelenkt werden.

15. Das System gemäß einem der Ansprüche 10 bis 14, dadurch gekennzeichnet, daß verschiedene elektrische Bauteile (20) verschiedene Kontaktglieder (12) auslenken.

## Revendications

1. Un connecteur (8) destiné à venir en contact avec un composant électrique (20) comprenant:
un boîtier (10) qui inclut un moyen (10a, 52) de positionnement dudit composant (20) dans une relation physique spécifiée par rapport audit boîtier (10);
un moyen conducteur (14) et une série d'organes de contact (12) portés par ledit boîtier (10) et sollicités par rapport à celui-ci entre une première et une deuxième positions d'une manière telle qu'au moins certains desdits organes de contact sollicités (12) sont placés, dans ladite première position, dans une relation électriquement conductrice avec ledit moyen conducteur (14) lorsqu'aucun composant électrique (20) n'est dans ladite relation physique spécifiée avec ledit boîtier (10) et d'une manière telle que des organes de contact choisis (12) sont placés en contact physique avec un composant électrique prédéterminé (20) dans ladite relation physique spécifiée par rapport audit boîtier et sont déplacés, dans ladite deuxième position, hors de leurs relation électriquement conductrice avec ledit moyen conducteur (14) lorsque ledit composant électrique (20) est dans ladite relation physique spécifiée avec ledit boîtier (10),
caractérisé en ce qu'il comprend en outre un moyen (80, 82, 84, 30) relié auxdits organes de contact (12) pour déterminer la combinaison de déplacements desdits organes de contact (12) lorsqu'un composant électrique (20) est dans ladite relation physique spécifiée par rapport audit boîtier (10), et pour identifier le composant (20) en réponse à cette détermination.

2. Le connecteur selon la revendication 1, dans lequel ledit moyen (80, 82, 84, 30) d'identification comprend un moyen (30) de comparaison entre une combinaison de signaux détectés en rapport avec lesdits organes de contact (12) et des données mémorisées qui représentent une série de combinaisons mémorisées de signaux, et d'identification du composant (20) en réponse à une correspondance entre la combinaison détectée des signaux et l'une des combinaisons mémorisées de signaux.

3. Le connecteur selon l'une des revendications 1 ou 2, comprenant en outre un moyen (84, 30) d'application de signaux prédéterminés audit composant (20) tandis qu'il est dans ladite relation physique spécifiée avec ledit boîtier (10) et un moyen (84, 30) de surveillance de la réponse du composant (20) à cette application.

4. Le connecteur selon l'une des revendications 1 ou 3, dans lequel chacun des organes de contact (12) dudit connecteur (8) comprend une partie fixe (12a) montée dans ledit boîtier (10), une partie de borne (12e) destinée à une connexion électrique à un conducteur (82), et une partie mobile (12b) au moins partiellement exposée par rapport audit boîtier (10) et apte à venir en prise avec un élément de contact (28) situé sur ledit composant électrique (20), au moins ladite partie mobile (12b) étant sollicitée vers une position de repos à partir de laquelle elle est déplacée lorsqu'elle vient en prise avec un élément de contact (28) dudit composant (20).

5. Le connecteur selon la revendication 4, dans lequel ledit moyen conducteur comprend un moyen de mise en court-circuit (14) apte à venir en contact physique et à être en relation électriquement conductrice avec les parties mobiles (12b) d'au moins certains desdits organes conducteurs (12) dans le cas de ladite position de repos.

6. Le connecteur selon la revendication 5, dans lequel ladite série d'organes de contact (12) est agencée en au moins une rangée et ledit moyen de mise court-circuit (14) comprend une barre conductrice qui s'étend transversalement à ladite rangée.

7. Le connecteur selon l'une des revendications 4 à 6 dans lequel chacun desdits organes de contact (12) est formé de manière à définir une partie incurvée (12c) entre ladite partie fixe (12a) et ladite partie mobile (12b), de façon que ladite partie incurvée (12c) se fléchisse afin d'exercer ladite sollicitation sur ladite partie mobile (12b).

8. Le connecteur selon la revendication 6, dans lequel ladite barre de court-circuit (14) s'étend transversalement aux parties mobiles (12b) de ladite rangée d'organes de contact (12).

9. Le connecteur selon l'une quelconque des revendications 5, 6 ou 8, dans lequel le moyen de mise en court-circuit (14) est mis à la masse.

10. Un système comprenant en combinaison un conducteur (8) selon l'une quelconque des revendications 1 à 9 et un composant électrique (20), ledit composant (20) comprenant un corps (22) qui comprend un moyen de positionnement (50) et un certain nombre d'éléments de contact exposés (28), ledit moyen de positionnement (50) du composant (20) étant apte à concorder avec ledit moyen de positionnement (50) du connecteur (8) de façon que la position physique des éléments de contact (28) sur le composant (20) soit définie par rapport aux organes de contact (12) du connecteur (8).

11. Le système selon la revendication 10, dans lequel au moins certains des organes de contact (12) sont en relation électriquement conductrice avec des éléments en contact (28) dudit composant, quand un composant électrique (20) est dans ladite relation physique par rapport audit boîtier (10), et dans lequel au moins certains des organes de contact (12 sont alors identifiés par ledit moyen de détermination (80, 82, 84, 30).

12. Le système selon l'une des revendications 10 ou 11, dans lequel les composants (20) de chaque classe d'une série de classes de composants électriques envoient des combinaisons spéciales de signaux auxdits organes de contact (12) lorsqu'ils sont dans ladite relation physique spécifiée par rapport audit boîtier (10).

13. Le système selon la revendication 12, dans lequel les composants (20) de chacune des classes possèdent des configurations physiques telles que des combinaisons différentes desdits organes de contact spéciales à chacune desdites classes sont déplacées à l'écart de leur dite relation électriquement conductrice avec ledit moyen conducteur (14), lorsque les composants (20) sont placés dans ladite relation physique par rapport audit boîtier (10).

14. Le système selon la revendication 13, dans lequel certaines desdites combinaisons desdits organes de contact sont déplacées par des organes électriquement isolants (22b) situés sur ledit composant (20).

15. Le système selon l'une des revendications 10 à 14, dans lequel des composants électriques différents (20) déplacent des organes de contact différents (12).
